(19) Europäisches Patentamt

European Patent Office

Office européen des brevets

(11) **EP 4 400 476 A1**

(12) **EUROPEAN PATENT APPLICATION**
published in accordance with Art. 153(4) EPC

(43) Date of publication:
**17.07.2024 Bulletin 2024/29**

(21) Application number: **22886128.2**

(22) Date of filing: **28.10.2022**

(51) International Patent Classification (IPC):
*C01B 32/00* (2017.01)   *C01B 32/205* (2017.01)
*C01B 32/21* (2017.01)   *H05K 7/20* (2006.01)

(52) Cooperative Patent Classification (CPC):
Y02E 10/549; Y02E 60/10

(86) International application number:
**PCT/CN2022/128267**

(87) International publication number:
**WO 2023/072253 (04.05.2023 Gazette 2023/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.10.2021 CN 202111278314**

(71) Applicant: **Huawei Technologies Co., Ltd. Shenzhen, Guangdong 518129 (CN)**

(72) Inventors:
• **FANG, Haoming**
  **Shenzhen, Guangdong 518129 (CN)**
• **JIN, Linfang**
  **Shenzhen, Guangdong 518129 (CN)**

(74) Representative: **Körber, Martin Hans**
  **Mitscherlich PartmbB**
  **Patent- und Rechtsanwälte**
  **Karlstraße 7**
  **80333 München (DE)**

(54) **CARBON MATERIAL AND APPLICATION THEREOF**

(57) A carbon material is disclosed. The carbon material includes a plurality of stacked carbon atom layers. A proportion of interlayer turbostratic stacking of the plurality of stacked carbon atom layers in the carbon material is greater than or equal to 20%. In-plane thermal diffusivity of the carbon material is greater than or equal to 750 mm$^2$/s. The proportion of interlayer turbostratic stacking of the carbon atom layers in the carbon material is controlled to be greater than or equal to 20% by a specific process. In this way, the carbon material has high in-plane thermal diffusivity, and can meet a heat dissipation requirement of a device with a high heat flux. The carbon material may be used in an electronic device, a heat dissipation module, a battery system, and a semiconductor structure.

FIG. 1c

EP 4 400 476 A1

## Description

This application claims priority to Chinese Patent Application No. 202111278314.4, filed with the China National Intellectual Property Administration on October 30, 2021 and entitled "CARBON MATERIAL AND APPLICATION THEREOF", which is incorporated herein by reference in its entirety.

## TECHNICAL FIELD

Embodiments of this application relate to the field of heat dissipation technologies, and in particular, to a carbon material and application thereof.

## BACKGROUND

With miniaturized, highly integrated, and multi-functional development of electronic devices, heat spot failures in electronic devices have become a key challenge in the field of consumer electronics. To quickly equalize heat at heat spots of a high-power chip, a conventional means is to equalize heat by using a heat pipe (Heat Pipe, HP) or a vapor chamber (vapor chamber, VC, also referred to as a planar heat pipe). However, heat equalization based on the HP or the VC has disadvantages of a high thickness, a large size, heavy mass, inflexible bending, high costs, and the like, and is not applicable to small electronic products, such as terminal foldable mobile phones or wearable devices (glasses or watches), or the field of vehicle-mounted batteries in a vibration scenario with a high requirement for safety performance.

A highly oriented carbon material has high thermal diffusivity and thermal conductivity, and superb stability and corrosion resistance, and therefore has become a hot research topic in the academia and industry. Thermally conductive graphite sheets are a type of thermally conductive heat dissipation material that is first introduced in the field of consumer electronics, and has currently been widely used in the fields of liquid crystal electronic rear screens, notebook computers, energy power devices, light emitting diodes, terminal mobile phones, and the like. An artificial graphite film is prepared by using polyimide as a raw material. Limited by the raw material and a graphitization process route, an existing artificial graphite film has disadvantages of low thermal diffusivity ($\leq 700$ mm$^2$/s), low thermal conductivity (usually lower than 1200 W/mK), a small film thickness ($\leq 80$ $\mu$m), and the like, and therefore cannot adapt to a scenario with a high heat flux and a high requirement ($\geq 200$ $\mu$m) for a thickness of a thermal spreader film. Graphene theoretically has an ultra-high thermal conductivity of 5300 W/mK. However, a graphene film prepared in the related art has many internal defects and a low degree of graphitization. Consequently, in-plane thermal diffusivity (to be specific, in an XY direction) is less than or equal to 700 mm$^2$/s, pristine-film cohesion is low, and no pristine film with a thickness greater than or equal to 0.2 mm can be formed. Therefore, the graphene film can hardly adapt to a scenario with a high heat flux and a high requirement for a thickness of a thermal spreader film either.

## SUMMARY

In view of this, embodiments of this application provide a carbon material and application thereof. In-plane thermal diffusivity of the carbon material is greater than or equal to 750 mm$^2$/s, and the carbon material has good heat-diffusion property, so that a heat dissipation requirement of a device with a high heat flux can be met.

Specifically, a first aspect of embodiments of this application provides a carbon material. The carbon material includes a plurality of stacked carbon atom layers. A proportion of interlayer turbostratic stacking of the plurality of stacked carbon atom layers in the carbon material is greater than or equal to 20%. In-plane thermal diffusivity of the carbon material is greater than or equal to 750 mm$^2$/s.

In the carbon material, some of the plurality of carbon atom layers are stacked in an ABA stacking mode (Graphite carbon, G carbon), and the others are stacked in a turbostratic stacking mode (Turbostratic carbon, Ts carbon). Turbostratic stacking is ABC stacking. Compared with an ABC stacked structure, an ABA stacked structure has a shorter interlayer distance between carbon atom layers, and the shorter interlayer distance causes poor interlayer phonon-based heat dissipation. Therefore, thermal diffusivity and thermal conductivity of a material can hardly be greatly increased. In embodiments of this application, the proportion of turbostratic stacking of the carbon atom layers in the carbon material is high, and correspondingly a proportion of ABA stacking is reduced. The proportion of turbostratic stacking of the carbon atom layers is increased, so that the in-plane thermal diffusivity of the carbon material is greatly increased. The carbon material in embodiments of this application has quite high thermal diffusivity, and can implement fast thermal diffusion in a direction of an X-Y plane. The carbon material may be used in a device with a high heat dissipation requirement in a form of a large-area film, sheet, or plate, to equalize heat for a heat emitting point of the device and quickly transfer heat at a heat spot. This avoids heat spot failures, and improves safety and stability of the device.

In an implementation of this application, a crystallographic $L_c$ size of a grain of the carbon material is greater than or equal to 50 nm. In this application, the $L_c$ size of the grain of the carbon material is large, so that a carbon material having a pristine film characteristic within a large thickness range can be obtained, and the carbon material can be used in a scenario with a high requirement for a thickness of a thermal spreader film. This avoids obtaining a thick carbon material through bonding by using a plurality of layers of adhesive, to better meet a heat dissipation requirement of a device with higher power consumption in 5G.

In an implementation of this application, a proportion of C=C in the carbon material is greater than or equal to 80%. A higher proportion of carbon-carbon double bonds C=C in the carbon material indicates a higher degree of graphitization of the carbon material, and a higher degree of graphitization is more conducive to achieving higher thermal diffusivity.

In an implementation of this application, the carbon material has a pristine film characteristic within a thickness range of less than or equal to 2 mm. The carbon material in this application has the pristine film characteristic within the thickness range of less than or equal to 2 mm. To be specific, no carbon material within a thickness range of 2 mm needs to be bonded by using adhesive. This can improve heat-diffusion property and structural stability of the carbon material, to better meet an application requirement in the case of a large thickness.

In an implementation of this application, the carbon material is bendable. The carbon material has a bendability characteristic, and therefore can better adapt to an application scenario with a bending requirement, for example, a terminal device with a foldable screen. When the carbon material is used in the terminal device with the foldable screen, the carbon material may be disposed across two or more screens.

In an implementation of this application, a crystallographic $L_a$ size of the grain of the carbon material is greater than or equal to 10 $\mu$m. In this application, the carbon material has a large monocrystalline $L_a$ size, so that a large phonon free-path can be obtained, to improve heat-conducting property of the carbon material and achieve high thermal diffusivity.

In an implementation of this application, an interlayer distance between the plurality of stacked carbon atom layers is greater than or equal to 0.3 nm and less than or equal to 0.5 nm. A small distance between carbon layers helps improve in-plane heat-diffusion property of the carbon material.

In an implementation of this application, elongation at break of the carbon material is greater than or equal to 1%. In an implementation of this application, breaking strength of the carbon material is greater than or equal to 30 MPa. In embodiments of this application, the carbon material has high elongation at break and high breaking strength. This indicates that the carbon material has good flexibility, elasticity, and tensile property, and can be well used in an application scenario with a bending requirement.

In an implementation of this application, surface roughness Ra of the carbon material is less than or equal to 1 $\mu$m. In embodiments of this application, the surface roughness of the carbon material is low. This facilitates phonon conduction, and achieves good effect on improving heat-conducting property of the carbon material.

In an implementation of this application, the carbon material includes a carbon film, a carbon sheet, or a carbon plate.

In an implementation of this application, the carbon material is obtained by graphitizing graphite oxide. A raw material is easy to obtain. This facilitates industrial production.

A second aspect of embodiments of this application provides a device. The device includes the foregoing carbon material. The carbon material may serve as a heat dissipation component to dissipate heat for the device. The device may be various devices with a heat dissipation requirement, for example, a mobile phone, a tablet computer, a notebook computer, a wearable device (for example, glasses or a watch), a display device, a television, an adapter, a router, a vehicle-mounted device, a vehicle-mounted display, a gateway, a set-top box, a charging base, a heat dissipation module, a battery system, a power device, or a packaged module.

A third aspect of embodiments of this application provides an electronic device. The electronic device includes the foregoing carbon material. The carbon material in embodiments of this application is used in the electronic device for heat dissipation and heat equalization. The carbon material has good heat-dissipation and heat-equalization property. In addition, a location, a shape, and a size of the carbon material in the electronic device are flexibly designed, and the carbon material is easy to assemble and fasten, and can well meet a heat dissipation requirement of the electronic device.

In an implementation of this application, the electronic device includes a display, a middle frame, a rear cover, and a circuit board, the middle frame is configured to carry the display and the circuit board, the middle frame is located between the display and the rear cover, and the carbon material is disposed between the middle frame and the rear cover and/or between the middle frame and the display.

In an implementation of this application, the electronic device further includes a two-phase liquid-cooled heat dissipation component, and the two-phase liquid-cooled heat dissipation component is fastened to a surface of the carbon material, or the two-phase liquid-cooled heat dissipation component is partially or fully embedded in the carbon material.

In an implementation of this application, the two-phase liquid-cooled heat dissipation component is bonded or welded to the carbon material.

In an implementation of this application, the two-phase liquid-cooled heat dissipation component includes a heat pipe and/or a vapor chamber.

Embodiments of this application further provide a heat dissipation module. The heat dissipation module includes the foregoing carbon material.

In an implementation of this application, the heat dissipation module includes a base and a heat-dissipation fin disposed on the base, and the base and/or the heat-dissipation fin are made of the carbon material.

In an implementation of this application, the heat dissipation module further includes a heat pipe and/or a vapor chamber connected to the base and the heat-dissipation fin.

Embodiments of this application provide a battery system. The battery system includes the foregoing carbon material.

In an implementation of this application, the battery system includes a plurality of battery packs, each battery pack includes a plurality of battery cells connected in series, and the carbon material is disposed between the plurality of battery packs and/or between the plurality of battery cells connected in series. In embodiments of this application, the carbon material is disposed between battery packs or between battery cells, to effectively equalize heat and dissipate heat in the battery system, and avoid appearance of heat spots in the battery system.

Embodiments of this application further provide a semiconductor structure. The semiconductor structure includes a semiconductor chip and a carbon material covering the semiconductor chip. The carbon material includes the carbon material according to the first aspect of embodiments of this application. The carbon material in embodiments of this application has good heat-conducting property and a low thermal expansion rate. This helps reduce thermal stress in a semiconductor chip.

## BRIEF DESCRIPTION OF DRAWINGS

FIG. 1a is a schematic diagram of a structure of a carbon material 100 according to an implementation of this application;

FIG. 1b is a schematic diagram of carbon atom layers in a carbon material 100 stacked in an ABA stacking mode according to an embodiment of this application;

FIG. 1c is a schematic diagram of carbon atom layers in a carbon material 100 stacked in a turbostratic stacking mode according to an embodiment of this application;

FIG. 2a and FIG. 2b are schematic diagrams of selecting sampling points on a carbon material when parameter characterization is performed on a carbon material;

FIG. 3 is a diagram of comparison between results of thermal diffusivity of a carbon material in a direction of an X-Y plane and a proportion of turbostratic stacking of carbon atom layers in a graphitization solution in which a catalyst is used and results in a control group solution in which no catalyst is used according to some embodiments of this application;

FIG. 4 is a diagram of comparison between results of thermal diffusivity in a direction of an X-Y plane of a carbon material and a particle size of graphite oxide in a low-temperature oxidation process solution and results in a control group solution in which a conventional oxidation process is used according to some embodiments of this application;

FIG. 5a and FIG. 5b are respectively a polarizing optical micrograph of a graphite oxide sheet obtained in a control group solution in which a conventional oxidation process is used and a polarizing optical micrograph of a graphite oxide sheet obtained in an oxidation process solution of this application;

FIG. 6a and FIG. 6b are respectively a diagram of distribution of fold structures on a surface of a carbon material obtained in a solution in which a biaxial stretching process is used and a diagram of distribution of fold structures on a surface of a carbon material obtained in a control group solution in which no stretching process is used according to some embodiments of this application;

FIG. 7 is a diagram of comparison between thermal diffusivity of a carbon material obtained in a solution in which a biaxial stretching process is used and thermal diffusivity of a carbon material obtained in a control group solution in which no stretching process is used according to some embodiments of this application;

FIG. 8 is a schematic diagram of a structure of an electronic device 200 according to an embodiment of this application;

FIG. 9a, FIG. 9b, and FIG. 9c are schematic exploded views of structures of an electronic device 200;

FIG. 9d and FIG. 9e are schematic diagrams of a carbon material, a shielding can, and a thermal interface material disposed in an electronic device 200;

FIG. 10 is a schematic diagram of a structure in which a carbon material 100 is fastened to a middle frame 202;

FIG. 11 is a schematic diagram of a structure in which a heat pipe 2051 and a vapor chamber 2052 are disposed on a surface of a carbon material 100;

FIG. 12 is a schematic diagram of a three-screen foldable device in which a carbon material is disposed on two screens;

FIG. 13 is a schematic diagram of a three-screen foldable device in which a carbon material is disposed on three screens;

FIG. 14, FIG. 15, FIG. 16a, FIG. 16b, and FIG. 17 are schematic diagrams of structures of a heat dissipation module 300 according to an embodiment of this application;

FIG. 18 is a schematic diagram of a carbon material 100 disposed between battery packs 410 in a battery system 400 according to an embodiment of this application;

FIG. 19 is a schematic diagram of a carbon material 100 disposed between battery cells 411 in a battery pack 410 in FIG. 18;

FIG. 20a is a schematic diagram of a carbon material 100 disposed in a semiconductor structure 500 according to an implementation;

FIG. 20b is a schematic diagram of a carbon material 100 in a semiconductor structure 500 according to another implementation;

FIG. 20c is a schematic diagram of a carbon material 100 in a semiconductor structure 500 according to another implementation;

FIG. 20d is a schematic diagram of a carbon material 100 in a semiconductor structure 500 according to another implementation; and

FIG. 21 is a Raman spectrum of a carbon material according to Embodiment 1.

## DESCRIPTION OF EMBODIMENTS

The following describes embodiments of this application with reference to accompanying drawings in embodiments of this application.

With miniaturized, highly integrated, and multi-functional development of electronic devices, a heat dissipation and heat equalization requirement of electronic devices is increasingly high. To better meet the heat dissipation and heat equalization requirement of electronic devices, embodiments of this application provide a highly oriented carbon material with superb heat-conducting and heat-dissipation property. Being highly oriented means that graphite crystal structures are oriented in a specific direction to form a carbon material in which most graphite crystals (100) are arranged along a crystal plane. The highly oriented carbon material can better achieve anisotropic heat-conducting and heat-dissipation property.

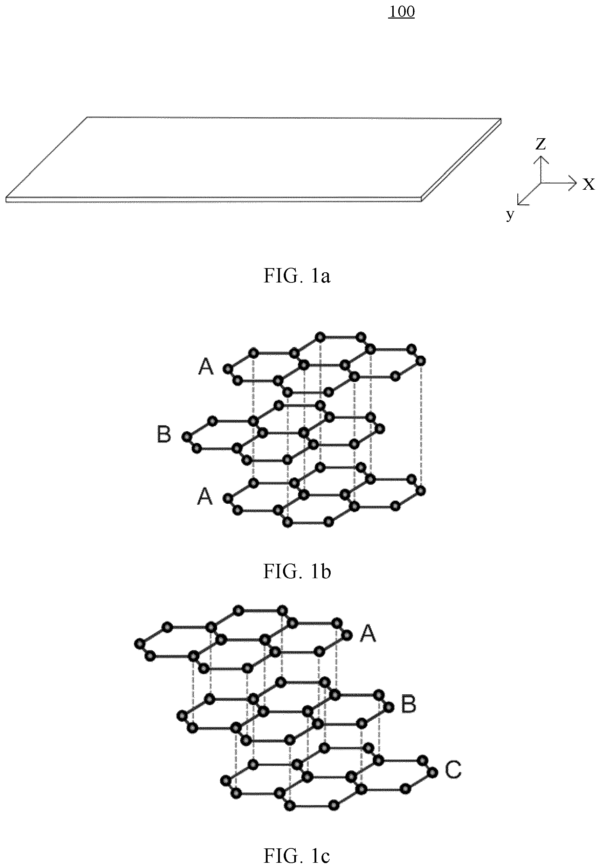

FIG. 1a is a schematic diagram of a structure of a carbon material 100 according to an implementation of this application. As shown in FIG. 1b and FIG. 1c, the carbon material 100 in embodiments of this application includes a plurality of stacked carbon atom layers 101. In the carbon material 100, some of the plurality of carbon atom layers 101 are stacked in an ABA stacking mode (Graphite carbon, G carbon), and the others are stacked in a turbostratic stacking mode (Turbostratic carbon, Ts carbon). Turbostratic stacking is ABC stacking. FIG. 1b is a schematic diagram of carbon atom layers in the carbon material 100 stacked in an ABA stacking mode according to an embodiment of this application. FIG. 1c is a schematic diagram of carbon atom layers in the carbon material 100 stacked in a turbostratic stacking mode according to an embodiment of this application. In an ABA stacked structure, carbon atom hexagons at a top layer A are precisely aligned with those at a bottom layer A, and those at a middle layer B are slightly shifted. In an ABC stacked structure, carbon atom hexagons at each carbon atom layer are slightly shifted forward compared with those at a lower layer.

In an implementation of this application, a proportion of interlayer turbostratic stacking of the plurality of stacked carbon atom layers 101 in the carbon material 100 is greater than or equal to 20%, in other words, a proportion of carbon atom layers that are stacked in the turbostratic stacking mode in the carbon material 100 is greater than or equal to 20%. The proportion of turbostratic stacking may be obtained by dividing a quantity of carbon atom layers (Turbostratic carbon, Ts carbon) stacked in the turbostratic stacking mode by a total quantity of carbon atom layers (Ts carbon) stacked in the turbostratic stacking mode and carbon atom layers (G carbon) stacked in the ABA stacking mode: Ts carbon/(Ts carbon+G carbon). Proportions of Ts carbon and G carbon may be obtained through analysis by using a Raman spectrum. Measurement may be performed by using a method in GB/T 40069-2021 Nanotechnologies-Measurement of the number of layers of graphene-related two-dimensional (2D) materials-Raman spectroscopy method. The proportion of Ts carbon is obtained based on measurement data. Specifically, the proportion of Ts carbon may be obtained by performing Lorentzian (Lorentzian) fitting on a G signal peak of the Raman spectrum.

In some implementations of this application, the proportion of interlayer turbostratic stacking of the carbon atom layers in the carbon material 100 is greater than or equal to 21%. In some other implementations, the proportion of interlayer turbostratic stacking of the carbon atom layers in the carbon material 100 is greater than or equal to 22%. In some other implementations, the proportion of interlayer turbostratic stacking of the carbon atom layers in the carbon material 100 is greater than or equal to 25%. In some embodiments of this application, the proportion of interlayer turbostratic stacking of the carbon atom layers in the carbon material 100 ranges from 21% to 25%. The ABA stacked structure has a shorter interlayer distance, and the shorter interlayer distance causes poor phonon-based heat dissipation between graphite layers. Therefore, thermal diffusivity and thermal conductivity of a material can hardly be greatly increased. In embodiments of this application, the proportion of turbostratic stacking of the carbon atom layers in the carbon material is high, and correspondingly a proportion of ABA stacking is reduced. The proportion of turbostratic stacking of the carbon atom layers is increased, so that the in-plane thermal diffusivity of the carbon material is greatly increased.

In an implementation of this application, as shown in FIG. 1a, in-plane thermal diffusivity of the carbon material 100 is greater than or equal to 750 $mm^2$/s. To be specific, thermal diffusivity of the carbon material 100 in a direction of an X-Y plane is greater than or equal to 750 $mm^2$/s. The direction of the X-Y plane is parallel to a direction of a plane of the carbon atom layers, and the direction of the X-Y plane is perpendicular to a Z direction, namely, a thickness direction, of the carbon material. Thermal diffusivity (thermal diffusivity) is a metric of a rate at which temperature disturbance at a point in an object is transferred to another point. A case in which temperature of an object rises due to heating is used as an example for analysis. During unsteady-state heat conduction in which temperature of an object rises due to heating, heat entering the object is continuously absorbed along a path, and therefore local temperature rises. This process continues until temperature at all points in the object is the same. A material with higher thermal diffusivity can make a human body more clearly feel that temperature is quickly transferred from one end of the material to the other end. In some implementations of this application, the in-plane thermal diffusivity of the carbon material 100 is greater than or equal to 760 $mm^2$/s. In some implementations, the in-plane thermal diffusivity of the carbon material 100 is greater than or equal to 780 $mm^2$/s. In some implementations, the in-plane thermal diffusivity of the carbon material 100 is greater than or equal to 800 $mm^2$/s. In some implementations, the in-plane thermal diffusivity of the carbon material 100 is greater than or equal to 850 $mm^2$/s. In some implementations, the in-plane thermal diffusivity of the carbon material 100 is greater than or equal to 900 $mm^2$/s. In some implementations, the in-plane thermal diffusivity of the carbon material 100 is greater than or equal to 1000 $mm^2$/s. Specifically, in embodiments of this application, the in-plane thermal diffusivity of the carbon material 100 may be 750 $mm^2$/s, 760 $mm^2$/s, 770 $mm^2$/s, 780 $mm^2$/s, 790 $mm^2$/s, 800 $mm^2$/s, 810 $mm^2$/s, 820 $mm^2$/s, 830 $mm^2$/s, 840 $mm^2$/s, 850 $mm^2$/s, 860 $mm^2$/s, 870 $mm^2$/s, 880 $mm^2$/s, 890 $mm^2$/s, 900 $mm^2$/s, 910 $mm^2$/s, 920 $mm^2$/s, 930 $mm^2$/s, 940 $mm^2$/s, 950 $mm^2$/s, 960 $mm^2$/s, 970 $mm^2$/s, 980 $mm^2$/s, 990 $mm^2$/s, 1000 $mm^2$/s, or 1100 $mm^2$/s. The carbon material 100 in embodiments of this application has quite high thermal diffusivity in the direction of the X-Y plane, and can implement fast thermal diffusion in the direction of the X-Y plane. The carbon material may be used in a device with a high heat dissipation requirement in a form of a large-area film, sheet, or plate, to equalize heat for a heat emitting point of the device and quickly transfer heat at a heat spot. This avoids heat spot failures, and improves safety and stability of the device.

In an implementation of this application, the carbon material is a material with anisotropic heat-conducting property. The thermal diffusivity of the carbon material 100 in the direction of the X-Y plane is greater than or equal to 750 $mm^2$/s, and thermal diffusivity of the carbon material 100 in the Z direction, namely, the thickness direction, is quite low, for example, may be 10 $mm^2$/s or lower. In some embodiments, the thermal diffusivity in the Z direction is 5 $mm^2$/s or lower, and in-plane thermal diffusivity may be 100 times the thermal diffusivity in the Z direction. In this way, heat can be better diffused in a plane, to meet a heat diffusion requirement of an electronic device such as a mobile phone.

In an implementation of this application, the thermal diffusivity of the carbon material may be measured with reference to GB/T 22588-2008 Determination of thermal diffusivity or thermal conductivity by the flash method. Specifically, the carbon material may be cut into a film with a diameter of 2 inches, and then corresponding thermal diffusivity is measured by using a laser thermal conductivity meter.

In an implementation of this application, a crystallographic $L_c$ size (Length in C-axis, C-axis size) of a monocrystalline grain of the carbon material is greater than or equal to 50 nm. In some implementations of this application, the crystallographic $L_c$ size of the monocrystalline grain of the carbon material is greater than or equal to 55 nm. In some implementations, the crystallographic $L_c$ size of the monocrystalline grain of the carbon material is greater than or equal to 60 nm. In some implementations, the crystallographic $L_c$ size of the monocrystalline grain of the carbon material is greater than or equal to 65 nm. In some implementations, the crystallographic $L_c$ size of the monocrystalline grain of the carbon material is greater than or equal to 70 nm. In this application, the $L_c$ size of the grain of the carbon material is large, so that a carbon material having a pristine film characteristic within a large thickness range can be obtained, and the carbon material can be used in a scenario with a high requirement for a thickness of a thermal spreader film. This avoids obtaining a thick carbon material through bonding by using a plurality of layers of adhesive, to better meet a heat dissipation requirement of a device with higher power consumption in 5G.

In an implementation of this application, a crystallographic $L_a$ size of the grain of the carbon material is greater than or equal to 10 $\mu$m. In some embodiments, the crystallographic $L_a$ size of the grain of the carbon material ranges from 10 $\mu$m to 100 $\mu$m (including the two endpoint values). Specifically, the crystallographic $L_a$ size of the grain of the carbon material may be 10 $\mu$m, 20 $\mu$m, 30 $\mu$m, 40 $\mu$m, 50 $\mu$m, 60 $\mu$m, 70 $\mu$m, 80 $\mu$m, 90 $\mu$m, or 100 $\mu$m. In this application, the carbon material has a large monocrystalline $L_a$ size, so that a large phonon free-path can be obtained, to improve heat-conducting property of the carbon material and achieve high thermal diffusivity. The $L_a$ size of the grain may be obtained through testing according to GB/T 40069-2021 Nanotechnologies-Measurement of the number of layers of graphene-related two-dimensional (2D) materials-Raman spectroscopy method. Specifically, a Raman signal on a surface of the carbon material may be observed: A test wavelength ranges from 1200 $cm^{-1}$ to 2800 $cm^{-1}$, and focus is put on a band of 1200 $cm^{-1}$ to 1800 $cm^{-1}$. A signal-to-noise ratio is greater than 20. A plurality of sampling points may be selected from the carbon material for testing. A laser wavelength used for testing may be 638 nm. In this application, a ratio of D-peak (about 1270 $cm^{-1}$) strength to G-peak (about 1580 $cm^{-1}$) strength in a Raman spectrum for a carbon material test may be as follows: $I_D/I_G < 0.01$, where $I_D/I_G$ is a ratio of a peak value on a D spectral band of the Raman spectrum to a peak value on a G spectral band.

In an implementation of this application, carbon atom layers are held together by Van der Waals forces. An interlayer distance between the plurality of stacked carbon atom layers may be greater than or equal to 0.3 nm and less than or equal to 0.5 nm. In some embodiments, the interlayer distance between the plurality of stacked carbon atom layers may be greater than or equal to 0.335 nm and less than or equal to 0.5 nm. A small distance between carbon layers helps improve in-plane heat-diffusion property of the carbon material.

The $L_c$ size of the grain and the interlayer distance between the carbon atom layers may be measured by using an X-ray powder diffraction (X-ray Powder Diffraction, XRD) method. A signal on the surface of the carbon material is observed: A test angle ranges from 10° to 60°, and focus is put on 20° to 30°, to be specific, information on a crystal plane (001). A plurality of sampling points may be selected from the carbon material for testing. An excitation wavelength of 1.5406 A may be used, and a copper (copper) K-$\alpha$ light source is used. The interlayer distance between the carbon atom layers and the $L_c$ size of the grain are calculated based on peak strength, a peak location, a full width at half maximum, and other information.

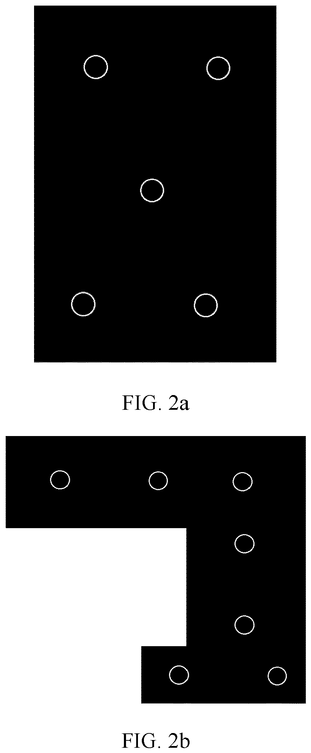

The foregoing parameters may be characterized by selecting sampling points, as shown in FIG. 2a and FIG. 2b. As shown in FIG. 2a, for a carbon film, a carbon sheet, or a carbon plate in a regular shape, five sampling points may be selected. As shown in FIG. 2b, for a carbon film, a carbon sheet, or a carbon plate in an irregular shape, seven sampling points may be selected. Each sampling point is at a geometric center of a relative region. Each sampling point may be tested three times. A test result for at least 50% of samples is used. Local defects and exceptions are not counted.

In an implementation of this application, a proportion of carbon-carbon double bonds C=C in the carbon material is greater than or equal to 80%. The proportion of carbon-carbon double bonds C=C in the carbon material is a proportion of a quantity of carbon atoms bonded in double bonds in the carbon material, that is, a molar proportion. A higher proportion of carbon-carbon double bonds C=C in the carbon material indicates a higher degree of graphitization of the carbon material, and a higher degree of graphitization is more conducive to achieving higher thermal diffusivity. In an implementation of this application, for example, the proportion of carbon-carbon double bonds C=C in the carbon material may be specifically 80%, 81%, 82%, 83%, 84%, 85%, 86%, 87%, 88%, 89%, or 90%. The proportion of C=C may be characterized by using X-ray photoelectron spectroscopy (XPS). Specifically, a fine spectrum (280 eV to 300 eV) of C is measured. After a fine peak of C is obtained, Lorentzian (Lorentzian) peak-differentiation-fitting is performed, and the proportion of C=C is determined based on an X-ray intensity value of a peak-differentiation result.

In an implementation of this application, the carbon material has high cohesion, and has a pristine film characteristic within a thickness range of less than or equal to 2 mm. In the related art, to obtain a carbon material with a thickness of 2 mm, a plurality of layers of pristine films need to be bonded by using adhesive. Disadvantages of the multi-layer bonding are as follows: A structure is unstable, the adhesive is likely to fail, and heat-dissipation property is poorer than that of a pristine film. The carbon material in this application has the pristine film characteristic within the thickness range of less than or equal to 2 mm. To be specific, no carbon material within a thickness range of 2 mm needs to be bonded by using adhesive. This can improve heat-diffusion property and structural stability of the carbon material. The carbon material may be prepared into an expected thickness according to a requirement. Specifically, a thickness of the carbon material may be 0.1 mm, 0.2 mm, 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2 mm, or the like. In some embodiments, if a heat dissipation carbon material with a larger thickness greater than 2 mm is needed, adhesive may alternatively be used for bonding.

In an implementation of this application, the carbon material is flexibly bendable. The carbon material has a bendability characteristic, and therefore can better adapt to an application scenario with a bending requirement, for example, a terminal device with a foldable screen. When the carbon material is used in the terminal device with the foldable screen, the carbon material may be disposed across two or more screens.

In an implementation of this application, elongation at break of the carbon material is greater than or equal to 1%. The elongation at break is a ratio of a post-stretching elongation length to a pre-stretching length in a case in which a specimen is subj ect to an external force until it breaks, namely, a ratio of an elongation length of the specimen at break to an initial length of the specimen, and is expressed as a percentage. The elongation at break may characterize flexibility and elasticity of the carbon material. In some embodiments of this application, the elongation at break of the carbon material ranges from 1% to 15%, and specifically, for example, may be 1%, 2%, 3%, 4%, 5%, 6%, 7%, 8%, 9%, 10%, 11%, 12%, 13%, 14%, or 15%.

In an implementation of this application, breaking strength of the carbon material is greater than or equal to 30 MPa. The breaking strength is maximum tensile stress recorded when a specimen is stretched to break. The breaking strength may characterize tensile property of the carbon material. In embodiments of this application, the carbon material has high elongation at break and high breaking strength. This indicates that the carbon material has good flexibility, elasticity, and tensile property, and can be well used in an application scenario with a bending requirement. In some implementations of this application, the breaking strength of the carbon material is greater than or equal to 40 MPa. In some embodiments of this application, the breaking strength of the carbon material ranges from 40 MPa to 80 MPa, and specifically, for example, may be 40 MPa, 50 MPa, 51 MPa, 60 MPa, 65 MPa, 70 MPa, 75 MPa, or 80 MPa. The elongation at break and the breaking strength of the carbon material may be obtained through testing by using a mechanics testing machine with reference to GB/T 13022-1991 Plastics-Determination of tensile properties of films. Specifically, the carbon material may be cut into a sample conforming to the Chine National Standards, a stress-strain curve is obtained by using the mechanics testing machine, and the elongation at break and the breaking strength are obtained by analyzing the stress-strain curve.

The carbon material 100 in embodiments of this application may have a hybrid crystal structure, to be specific, include both a monocrystal and a polycrystal.

In an implementation of this application, the carbon material 100 may be in a shape of a film, a sheet, a plate, or the like. In other words, the carbon material 100 may be a carbon film, a carbon sheet, or a carbon plate.

In an implementation of this application, surface roughness Ra of the carbon material 100 is less than or equal to 1 $\mu$m. Surface roughness Ra of an existing conventional carbon material is greater than 10 $\mu$m. The carbon material in embodiments of this application has high surface flatness, a few surface folds, and low surface roughness. The low surface roughness facilitates phonon conduction, and achieves good effect on improving heat-conducting property of the carbon material. In some embodiments of this application, for example, the surface roughness of the carbon material 100 may be specifically 1 $\mu$m, 0.95 $\mu$m, 0.9 $\mu$m, 0.85 $\mu$m, 0.8 $\mu$m, 0.7 $\mu$m, 0.6 $\mu$m, or 0.5 $\mu$m. For example, the surface roughness of the carbon material is surface roughness of a carbon film, a carbon sheet, or a carbon plate.

In an implementation of this application, the carbon material 100 is obtained by graphitizing graphite oxide.

The carbon material provided in embodiments of this application has high thermal diffusivity and can also have good bendability and have a pristine film characteristic within a large thickness range, and may be used in various scenarios with a heat dissipation requirement, to better adapt to a development requirement of a high-power device in 5G. For example, the carbon material in embodiments of this application may be used for heat equalization or heat dissipation for a heat emitting power device or module on a circuit board, or may be used for heat equalization or heat dissipation for a semiconductor chip or a heat emitting chip in a packaged module. The carbon material in embodiments of this application further has mass producibility, and expanded production and preparation can be implemented. In addition, the carbon material in this application is light. Compared with conventional heat dissipation by using an aluminum plate or a copper plate, in the case of heat dissipation by using the carbon material in this application, a weight of a device can be effectively reduced, and a large benefit of weight reduction is achieved. The carbon material in this application may be independently used in a form of a pure film or plate, or may be processed into a sheet, a film material, or a specific three-dimensional shape for use; or adhesion of the carbon material is increased by using an adhesive tape, by brushing glue, or the like, and the carbon material is used through pasting; or the carbon material may be welded to a metal mechanical part to form a heat dissipation mechanical module, or the like.

Embodiments of this application provide a method for preparing the foregoing carbon material, including the following steps.

S101: Disperse graphite oxide with a large particle size in a solvent, and add a catalyst to obtain a graphite oxide slurry.

S102: Apply the graphite oxide slurry to a substrate, dry the substrate, and then perform graphitization through high-temperature reduction to obtain a carbon material.

In step S101, the solvent may be water, anhydrous alcohol, N-methylpyrrolidone (NMP), or the like. The catalyst may be one or more of a transition metal catalyst and a boron catalyst. The transition metal catalyst may be specifically a transition metal or a transition metal compound. The transition metal catalyst may be an iron-cobalt-nickel catalyst. The iron-cobalt-nickel catalyst may be specifically one or more of iron oxide nanoparticles, ferrocene, tetraphenyl iron porphyrin, ferrous oxalate, ferric acetylacetonate, ferric chloride, nickel chloride, nickel oxide, cobalt chloride, and cobalt oxide. The boron catalyst may be one or more of triphenylborane, trimethyl borate, and bis(neopentyl glycolato)diboron. Content of a used transition metal catalyst is based on content of transition metal atoms. The content of the transition metal atoms accounts for 0.005% to 0.1% of content of the graphite oxide, or preferably, the content of the transition metal atoms accounts for 0.05% to 0.08% of the content of the graphite oxide. Content of a used boron catalyst is based on content of boron atoms. The content of the boron atoms accounts for 0.05% to 1% of the content of the graphite oxide, or preferably, the content of the boron atoms accounts for 0.1% to 0.5% of the content of the graphite oxide. The catalyst is added, so that a degree of graphitization repair of the carbon material can be improved, and the carbon material can be enabled to form more turbostratic stacking modes, to significantly increase a crystal size of the graphite oxide during subsequent high-temperature processing, and obtain a highly oriented carbon material with higher thermal diffusivity and thermal conductivity.

In some implementations of this application, a carbon source repair agent may be further added to the graphite oxide slurry, and the carbon source repair agent may include an organic molecule with good water solubility, for example, pyrenebutyric acid or ascorbic acid. The carbon source repair agent is added, so that a proportion of turbostratic stacking of carbon atom layers can be better increased. This helps obtain a carbon material with higher thermal diffusivity.

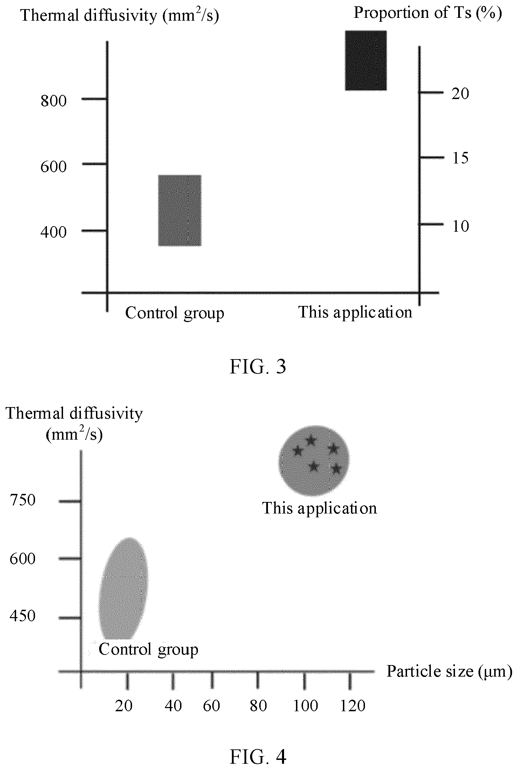

FIG. 3 is a diagram of comparison between results of thermal diffusivity of a carbon material in a direction of an X-Y plane and a proportion of turbostratic stacking of carbon atom layers in a graphitization solution in which a catalyst is used and results in a control group solution in which no catalyst is used according to some embodiments of this application. A difference between the control group solution in which no catalyst is used and the carbon material preparation method in embodiments of this application includes: No catalyst in this application is added. It can be learned from FIG. 3 that, in the catalyst-based graphitization solution in this application, a proportion of turbostratic stacking of a carbon material can be increased, and thermal diffusivity can be increased.

In an implementation of this application, graphite oxide with a large particle size may be prepared by using the following low-temperature process:

Concentrated sulfuric acid, potassium permanganate, or both concentrated sulfuric acid and potassium permanganate are added to a graphite raw material, so that graphite undergoes an oxidative stripping reaction for a period of time at 20°C to 40°C to obtain a graphite oxide solution with a large particle size.

In embodiments of this application, the concentrated sulfuric acid and the potassium permanganate are used as oxidants, and single-layer graphite oxide with a large particle size may be obtained through oxidative stripping at low temperature. Oxidants used in the foregoing policy of preparing graphite oxide with a large particle size at low temperature are the concentrated sulphuric acid and the potassium permanganate. A mass fraction of sulphuric acid in the concentrated sulphuric acid may range from 85% to 98.3%. In some embodiments, the mass fraction of the sulphuric acid may be greater than 95%. A higher concentration of the concentrated sulphuric acid is more conducive to obtaining single-layer graphite oxide. A concentration of the potassium permanganate may range from 0.01 g/mL to 0.2 g/mL. In some embodiments, the concentration of the potassium permanganate may range from 0.05 g/mL to 0.15 g/mL.

In some embodiments, temperature during an entire process of oxidative stripping of the graphite raw material may be controlled to be 25°C to 35°C. Specifically, in some embodiments, temperature during an entire process of oxidative stripping of the graphite oxide may be controlled to be approximately 30°C. In some embodiments, the temperature during oxidative stripping may be specifically 25°C, 26°C, 27°C, 28°C, 29°C, 30°C, 32°C, 34°C, or 35°C. Reaction time of the oxidative stripping may be 2 to 5 hours. In some embodiments, the reaction time may be controlled to be 3 to 4 hours, to obtain large-size single-layer graphite oxide through stripping.

The graphite raw material may be but is not limited to one or more of expandable graphite, flake graphite, high-purity graphite, and kish graphite, and preferably, is the expandable graphite. A particle size of the graphite raw material may range from 100 $\mu$m to 300 $\mu$m. In some embodiments, the particle size of the graphite raw material may range from 150 $\mu$m to 200 $\mu$m.

In the graphite oxide solution with a large particle size that is prepared above, surface oxygen content of the graphite oxide with a large particle size is identified by using X-ray photoelectron spectroscopy. A proportion of oxygen content of the graphite oxide with a large particle size is less than or equal to 40% and greater than or equal to 15%, and an average particle size of the graphite oxide with a large particle size is greater than or equal to 100 $\mu$m. In some embodiments, the average particle size of the graphite oxide with a large particle size is greater than or equal to 100 $\mu$m and less than or equal to 150 $\mu$m. A single-layer rate of the graphite oxide included in the graphite oxide solution with a large particle size is greater than 95%. A means of obtaining a graphite oxide sheet with a high single-layer rate is not limited to centrifugal sieving, filtering sieving, and the like.

In embodiments of this application, oxygen content of graphite oxide can be reduced from more than 50% in a conventional case to less than 40% by using the foregoing low-temperature oxidation process, and a large particle size of single-layer graphite oxide is also retained. Different from an existing conventional solution in which only a graphite oxide sheet material of 20 $\mu$m to 30 $\mu$m can be prepared, single-layer graphite oxide with a particle size of greater than 100 $\mu$m can be prepared by using the process in embodiments of this application.

In step S102, temperature for the graphitization through high-temperature reduction may range from 2200°C to 3500°C, and specifically, for example, may be 2200°C, 2500°C, 2900°C, 3000°C, 3100°C, 3200°C, 3300°C, or 3500°C.

A drying operation may be specifically performing drying at 100°C to 200°C for 10 min to 60 min.

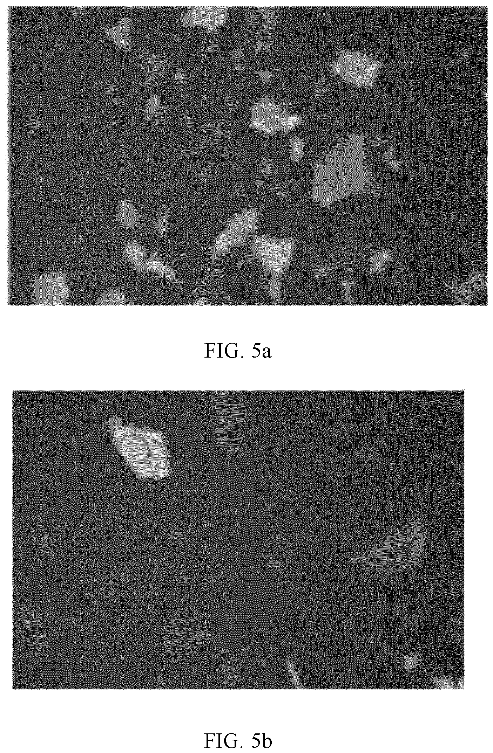

FIG. 4 is a diagram of comparison between results of thermal diffusivity in a direction of an X-Y plane of a carbon material and a particle size of graphite oxide in a low-temperature oxidation process solution and results in a control group solution in which a conventional oxidation process is used according to some embodiments of this application. A difference between the control group solution in which the conventional oxidation process is used and the carbon material preparation solution in embodiments of this application includes: A concentration of concentrated sulphuric acid used in the conventional oxidation process is different from a concentration of concentrated sulphuric acid used in the solution of this application, and reaction temperature ranges from 90°C to 100°C. FIG. 5a and FIG. 5b are respectively a polarizing optical micrograph of a graphite oxide sheet obtained in a control group solution in which a conventional oxidation process is used and a polarizing optical micrograph of a graphite oxide sheet obtained in an oxidation process of this application. It can be learned from FIG. 4, FIG. 5a, and FIG. 5b that a graphite oxide sheet with a larger particle size can be obtained by using the low-temperature oxidation process in this application, to obtain a carbon material with higher thermal diffusivity.

In an implementation of this application, to better improve thermal diffusivity of a prepared carbon material, biaxial stretching may be performed on the carbon material during hot pressing sintering before high-temperature graphitization. Biaxial stretching (biaxial drawing) is stretching along a longitudinal direction and a lateral direction of a plane of a film or a plate during preparation of the film or the plate. Stretching in two axial directions may be performed simultaneously or sequentially. Specifically, stretching may be performed by applying fixed pressure, for example, by any means of applying a force for stretching, for example, hanging a weight or using a screw for fastening. A magnitude of the applied force of the biaxial stretching may range from 10 N to 100 N, or may range from 30 N to 70 N in some embodiments. In a graphitization process in which biaxial stretching is performed for location limiting and fastening, constricted folds on a carbon material can be avoided during high-temperature processing, to reduce defect fold points and increase thermal diffusivity and thermal conductivity of the carbon material.

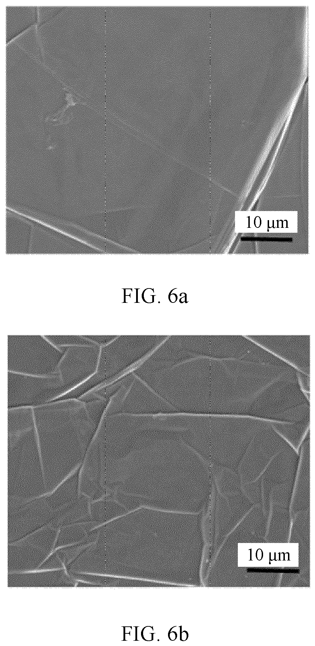

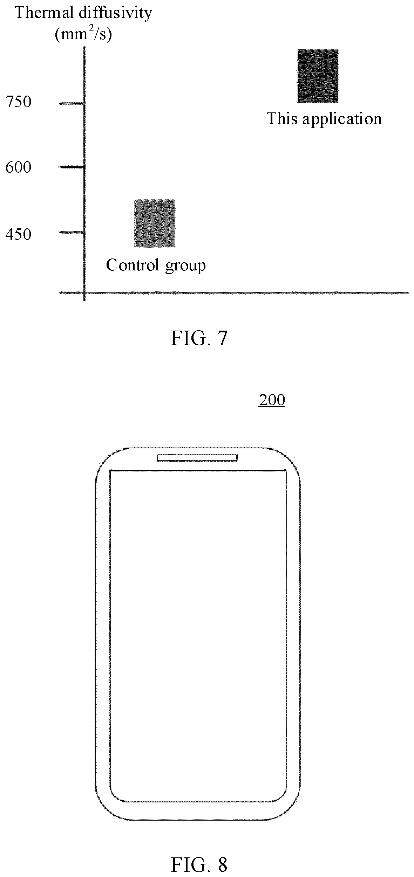

FIG. 6a and FIG. 6b are respectively a diagram of distribution of fold structures on a surface of a carbon material obtained in a solution in which a biaxial stretching process is used and a diagram of distribution of fold structures on a surface of a carbon material obtained in a control group solution in which no stretching process is used according to some embodiments of this application. It can be learned from FIG. 6a and FIG. 6b that, after the biaxial stretching process in this application is performed, fold structures distributed on the surface of the carbon material are significantly reduced, surface roughness of the carbon material 100 is reduced, and Ra is less than or equal to 1 $\mu$m. FIG. 7 is a diagram of comparison between thermal diffusivity of a carbon material obtained in a solution in which a biaxial stretching process is used and thermal diffusivity of a carbon material obtained in a control group solution in which no stretching process is used according to some embodiments of this application. It can be learned from FIG. 7 that the thermal diffusivity of the carbon material obtained by using the biaxial stretching process in this application is significantly increased. A difference between the control group solution in which no stretching process is used and the carbon material preparation method in embodiments of this application includes: No biaxial stretching process is used.

In an implementation of this application, before biaxial stretching is performed, the graphite oxide sheet may be immersed in anhydrous alcohol, and specifically, may be immersed in the anhydrous alcohol for 1 to 24 h.

Embodiments of this application provide a device. The device includes the carbon material 100 in embodiments of this application. The carbon material 100 may serve as a heat dissipation component to dissipate heat for the device. The device 200 may be various electronic devices, or may be a device other than the electronic devices. For example, the device may be specifically various devices with a heat dissipation requirement, for example, a mobile phone, a tablet computer, a notebook computer, a wearable device (for example, glasses or a watch), a display device, a television, an adapter, a router, a vehicle-mounted device, a vehicle-mounted display, a gateway, a set-top box, a charging base, a heat dissipation module, a battery system, a power device, or a packaged module.

As shown in FIG. 8, in some embodiments, the device is an electronic device 200. An example in which the electronic device 200 is a mobile phone is used below to specifically describe application of the carbon material 100 in the electronic device 200 in embodiments of this application.

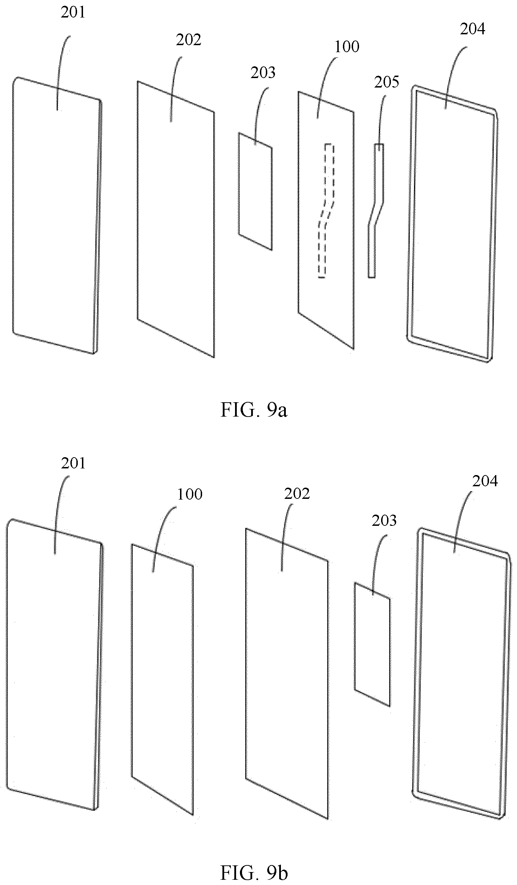

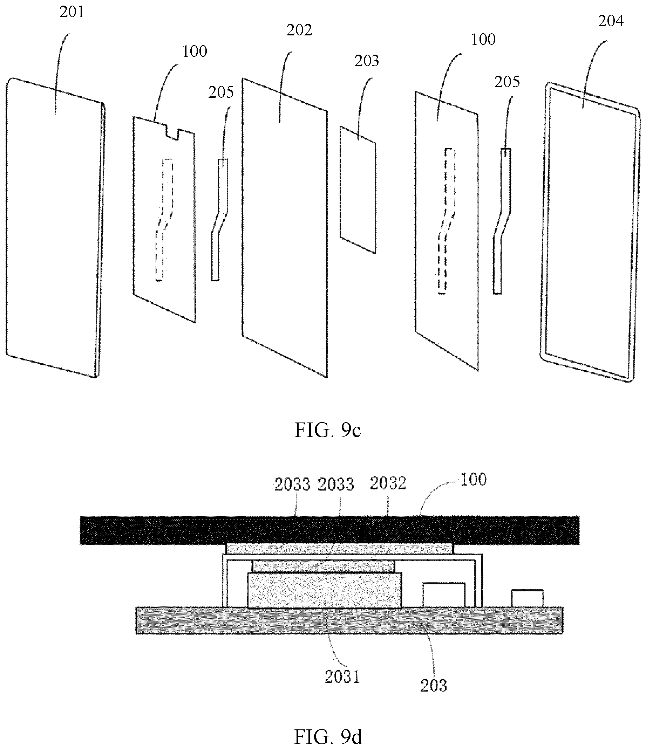

FIG. 9a, FIG. 9b, and FIG. 9c are schematic exploded views of structures of the electronic device 200. The electronic device 200 includes a display 201, a middle frame 202, a circuit board 203, and a rear cover 204. The middle frame 202 is located between the display 201 and the rear cover 204. The middle frame 202 is configured to carry the display 201 and the circuit board 203. The carbon material 100 may be located between the middle frame 202 and the rear cover 204, as shown in FIG. 9a; or may be located between the middle frame 202 and the display 201, as shown in FIG. 9b; or may be disposed between the middle frame 202 and the rear cover 204 and between the middle frame 202 and the display 201, as shown in FIG. 9c. A heat emitting component, for example, a chip, is disposed on the circuit board 203. The heat emitting component may be disposed on one side or both sides of the circuit board 203. The carbon material 100 disposed in the electronic device 200 may dissipate heat for the circuit board 203 and the display 201. In this way, heat generated at a heat emitting point in the electronic device 200 can be quickly conducted, to avoid appearance of a heat spot in the electronic device 200, and improve user experience and safety and stability of the electronic device 200. One carbon film, carbon sheet, or carbon plate may have a uniform thickness or nonuniform thicknesses. A shape and a size of the carbon material are not limited. The carbon material may be in a regular shape, for example, a square shape; or may be in an irregular shape. A shape, a thickness, and a size-on-an-X-Y-plane of a carbon material disposed between the middle frame 202 and the rear cover 204 may be the same as or different from those of a carbon material between the middle frame 202 and the display 201.

The carbon material 100 may be fastened to the middle frame 202 or the rear cover 204, and specifically, may be bonded or welded to the middle frame 202 or the rear cover 204, or may be embedded into the rear cover 204 through injection molding, where the injection molding helps reduce an overall thickness of the electronic device.

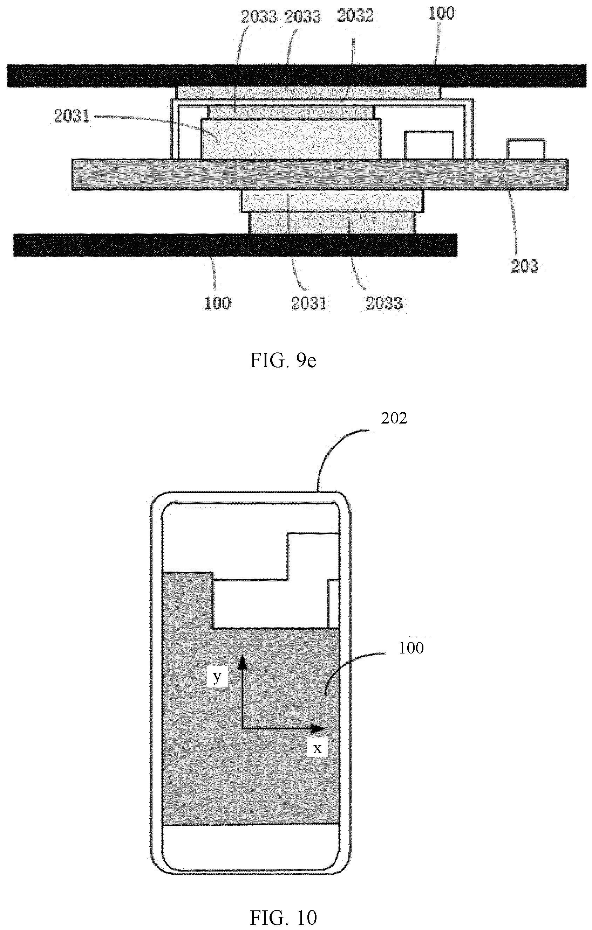

In some embodiments, as shown in FIG. 9d and FIG. 9e, a shielding can 2032 and/or a thermal interface material 2033 may be further disposed between the carbon material 100 and the heat emitting component 2031 on the circuit board 203. The shielding can and the thermal interface material are disposed, to better facilitate heat diffusion and conduction. As shown in FIG. 9d, the heat emitting component is disposed on one side of the circuit board 203, and both the shielding can 2032 and the thermal interface material 2033 are disposed between the carbon material 100 and the heat emitting component 2031 on the circuit board 203. As shown in FIG. 9e, the heat emitting component is disposed on both sides of the circuit board 203, and the carbon material 100 is disposed on the heat emitting component 2031 on both sides. The thermal interface material 2033 is disposed between the carbon material 100 and the heat emitting component 2031 on one side, and the shielding can 2032 and the thermal interface material 2033 are disposed between the carbon material 100 and the heat emitting component 2031 on the other side.

FIG. 10 is a schematic diagram of a structure in which the carbon material 100 is fastened to the middle frame 202. In an implementation of this application, a specific size and shape of the carbon material 100, locations of the carbon material 100 on the middle frame 202 and the rear cover 204, and the like may be designed based on a specific model of the electronic device and according to an actual heat dissipation requirement or the like. This is not particularly limited in this application. In some embodiments, the carbon material 100 may cover a main heat emitting component on the circuit board 203, or may cover each heat emitting component on the circuit board 203, or may cover the entire circuit board 203. In some embodiments, an orthographic projection of the carbon material 100 on the middle frame 202 partially or fully overlaps an orthographic projection of the circuit board 203 on the middle frame 202. In some embodiments, the carbon material 100 may alternatively be disposed around the circuit board 203. To be specific, an orthographic projection of the carbon material 100 on the middle frame 202 does not overlap an orthographic projection of the circuit board 203 on the middle frame 202. The carbon material in embodiments of this application has high thermal diffusivity in a direction of an X-Y plane, so that a heat flow can be quickly conducted in the direction of the X-Y plane, to quickly dissipate heat in the electronic device and avoid appearance of a heat spot.

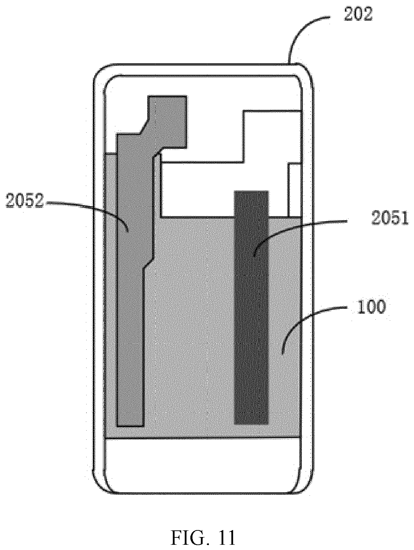

As shown in FIG. 9c and FIG. 11, in some implementations of this application, to further improve heat-dissipation property of the electronic device 200, the electronic device 200 further includes a two-phase liquid-cooled heat dissipation component 205. The two-phase liquid-cooled heat dissipation component 205 may include a heat pipe 2051 and/or a vapor chamber 2052, a loop heat pipe, or the like. To be specific, in the electronic device 200, the heat pipe 2051 may be further disposed, or the vapor chamber 2052 may be disposed, or both the heat pipe 2051 and the vapor chamber 2052 may be disposed. This may be specifically disposed according to an actual requirement. The two-phase liquid-cooled heat dissipation component is fastened to a surface of the carbon material, or the two-phase liquid-cooled heat dissipation component is partially or fully embedded in the carbon material. The carbon material may have a structure in a 2D or 2.5D form.

In some implementations of this application, as shown in FIG. 11, the heat pipe 2051 and the vapor chamber 2052 are fastened to the surface of the carbon material 100. To be specific, the heat pipe 2051 and the vapor chamber 2052 are attached to and in contact with the carbon material 100. Specifically, the heat pipe 2051 and the vapor chamber 2052 may be fastened to the carbon material 100 through bonding or welding.

In some implementations of this application, as shown in FIG. 9c, the two-phase liquid-cooled heat dissipation component 205 is partially or fully embedded in the carbon material 100. Specifically, the carbon material 100 may be provided with a groove, and the two-phase liquid-cooled heat dissipation component 205 is partially or fully embedded in the groove.

In an implementation of this application, the carbon material 100 is used in combination with the heat pipe 2051 and/or the vapor chamber 2052 to achieve good heat-diffusion property, and heat-diffusion effect thereof is far better than that of a conventional heat pipe or vapor chamber.

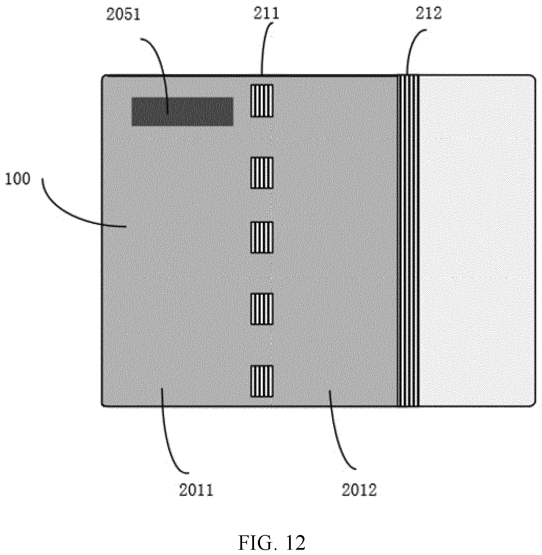

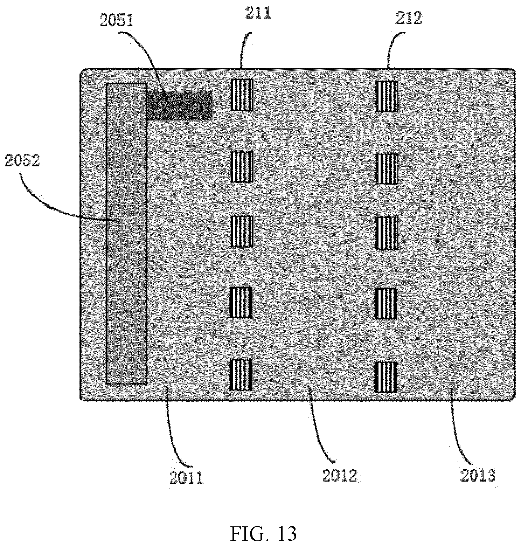

As shown in FIG. 12 and FIG. 13, in some embodiments of this application, the electronic device 200 may alternatively be a foldable device. FIG. 12 is a schematic diagram of a three-screen foldable device in which a carbon material is disposed on two screens. FIG. 13 is a schematic diagram of a three-screen foldable device in which a carbon material is disposed on three screens. As shown in FIG. 12, the electronic device 200 includes a first display region 2011, a second display region 2012, a third display region 2013, a first foldable part 211, and a second foldable part 212. The carbon material 100 is disposed across an axis, to be specific, across the first foldable part 211, to cover both the first display region 2011 and the second display region 2012. As shown in FIG. 13, the electronic device 200 includes a first display region 2011, a second display region 2012, a third display region 2013, a first foldable part 211, and a second foldable part 212. The carbon material 100 is disposed across axis, to be specific, across the first foldable part 211 and the second foldable part 212, to cover all of the first display region 2011, the second display region 2012, and the third display region 2013. The carbon material 100 in embodiments of this application has good bendability and heat-diffusion property, and may be disposed across an axis to meet bending and heat dissipation requirements of a multi-screen foldable device, for example, a two-screen foldable device or a three-screen folding device. To improve heat-dissipation property of a foldable device, as shown in FIG. 12 and FIG. 13, a heat pipe 2051 and/or a vapor chamber 2052 may be further disposed on the carbon material 100 in the foldable device.

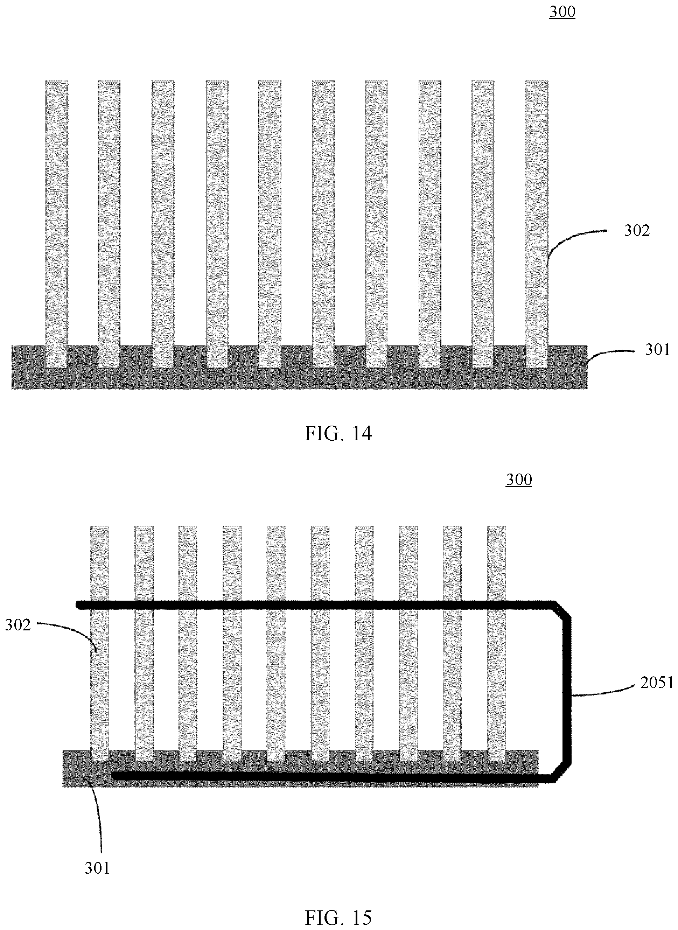

As shown in FIG. 14 to FIG. 17, embodiments of this application further provide a heat dissipation module 300. The heat dissipation module 300 includes the carbon material 100 in embodiments of this application. In an implementation of this application, the heat dissipation module 300 includes a base 301 and a heat-dissipation fin 302 disposed on the base 301. In some implementations, the heat-dissipation fin 302 is made of the carbon material 100. In some embodiments, the base 301 is made of the carbon material 100. In some embodiments, both the base 301 and the heat-dissipation fin 302 are made of the carbon material 100. The heat-dissipation fin 302 may be fastened to the base 301 through welding, bonding, interference fit, or the like.

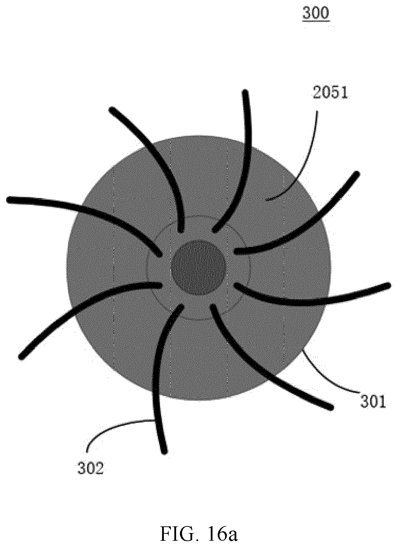

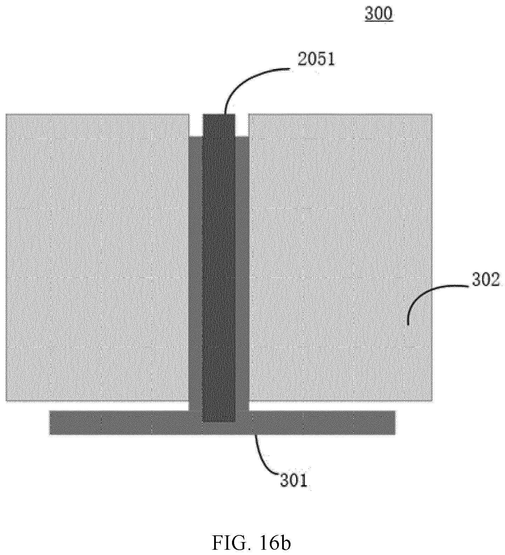

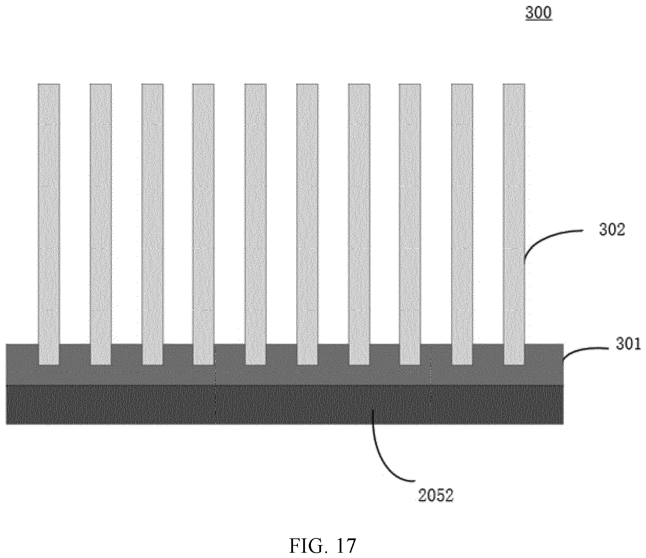

In an implementation of this application, the heat dissipation module 300 further includes a heat pipe 2051 and/or a vapor chamber 2052 connected to the base 301 and the heat-dissipation fin 302. In some implementations of this application, the heat dissipation module 300 is a heat pipe-based heat dissipation module. In some implementations, the heat dissipation module 300 is a vapor chamber-based heat dissipation module. FIG. 15 is a schematic diagram of a structure of a heat pipe-based heat dissipation module according to an embodiment of this application. A heat pipe 2051 is connected to a base 301 and a heat-dissipation fin 302. FIG. 16a and FIG. 16b are schematic diagrams of structures of a heat pipe-based heat dissipation module according to another embodiment of this application. FIG. 16a is a schematic top view of a structure. FIG. 16b is a schematic cross-sectional view of a structure. In the heat pipe-based heat dissipation module shown in FIG. 16a and FIG. 16b, the heat-dissipation fin 302 is an arc-shaped heat-dissipation fin, and the arc-shaped heat-dissipation fin is made of the carbon material 100 in embodiments of this application. The carbon material 100 in this application has good bendability, and therefore can meet an arc-shaped disposing requirement. A heat pipe 2051 disposed in the middle of the arc-shaped heat-dissipation fin 302 can enhance heat conduction from the base 301 to the heat-dissipation fin 302. FIG. 17 is a schematic diagram of a structure of a vapor chamber-based heat dissipation module according to an embodiment of this application. A vapor chamber 2052 is connected to a base 301. The vapor chamber-based heat dissipation module may be used in a large heat emitting device, for example, a server, to achieve efficient heat equalization and heat dissipation effect and maintain normal use of the device.

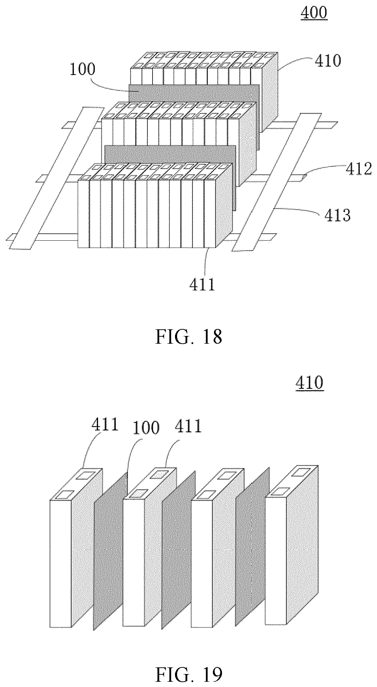

As shown in FIG. 18, embodiments of this application further provide a battery system 400. The battery system 400 includes a plurality of battery packs 410. Each battery pack 410 includes a plurality of battery cells 411 connected in series. A heat dissipation apparatus is disposed below the battery pack 410. In some embodiments, the heat dissipation apparatus may include a vapor chamber 412 and a coolant pipe 413. In some embodiments of this application, as shown in FIG. 18, the carbon material 100 is disposed between the plurality of battery packs 410, to be specific, between a battery pack 410 and another battery pack 410, for heat dissipation. In some embodiments of this application, as shown in FIG. 19, the carbon material 100 is disposed between the plurality of battery cells 411 connected in series, to be specific, between a battery cell 411 and another battery cell 411, for heat dissipation. In some embodiments, the carbon material 100 may alternatively be disposed both between battery packs 410 and between battery cells 411 for heat dissipation. In actual application, the carbon material 100 may be used in combination with an insulation film, insulation adhesive, a heat insulation material, a heat storage material, a fire extinguishing material, or the like. The carbon material may be coated with these materials. It should be particularly noted that temperature during sintering of the highly oriented carbon material in this application is higher than 2000°C, and the carbon material has superb high temperature resistance and heat equalization characteristics.

In embodiments of this application, thermal diffusivity of the carbon material in a direction of an X-Y plane is far higher than thermal diffusivity in a Z direction. The carbon material is an anisotropic material. When thermal runaway occurs in a battery cell in the battery system 400, after heat is transferred to the carbon material, heat can be quickly transferred to the heat dissipation apparatus based on good heat-diffusion property of the carbon material in the direction of the X-Y plane, and poor heat-diffusion property in the Z direction can well prevent heat from being transferred to another normal battery cell around, to avoid a chain reaction caused by the thermal runaway. Therefore, the carbon material in embodiments of this application is disposed between battery packs or between battery cells, to effectively control a direction of a heat flow based on anisotropy of the carbon material and prevent thermal runaway from spreading between battery cells, so that heat is efficiently transferred to a heat dissipation apparatus above or below a battery cell.

In embodiments of this application, to more effectively suppress spreading of thermal runaway of a battery, a thermal buffer layer may be disposed on a surface on one side or both sides of the carbon material 100. The thermal buffer layer may perform a heat insulation function. When thermal runaway occurs in a battery cell in the battery system 400, the thermal runaway can be better prevented from spreading from the battery cell in which the thermal runaway occurs to another battery cell. The thermal buffer layer may include one or more of magnesium carbonate, a heat-resistant resin material, and a heat insulation gel material. In some embodiments, the thermal buffer layer is a composite layer of magnesium carbonate and a heat-resistant resin material. In some embodiments, the thermal buffer layer is a composite layer of magnesium carbonate, a heat-resistant resin material, and a heat insulation gel material.

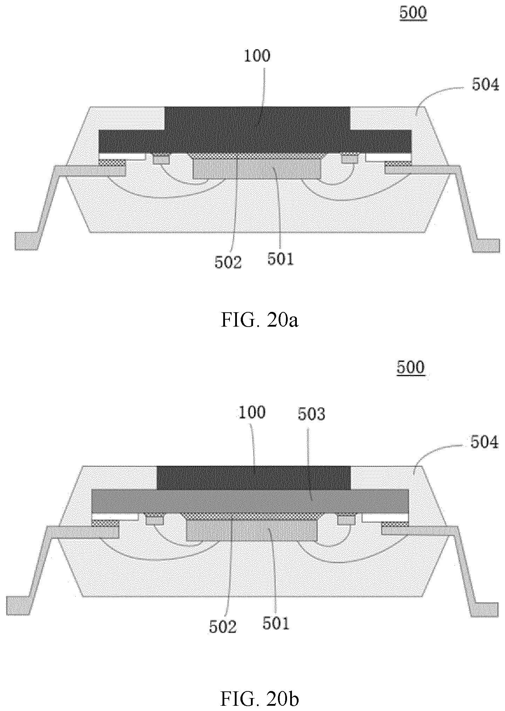

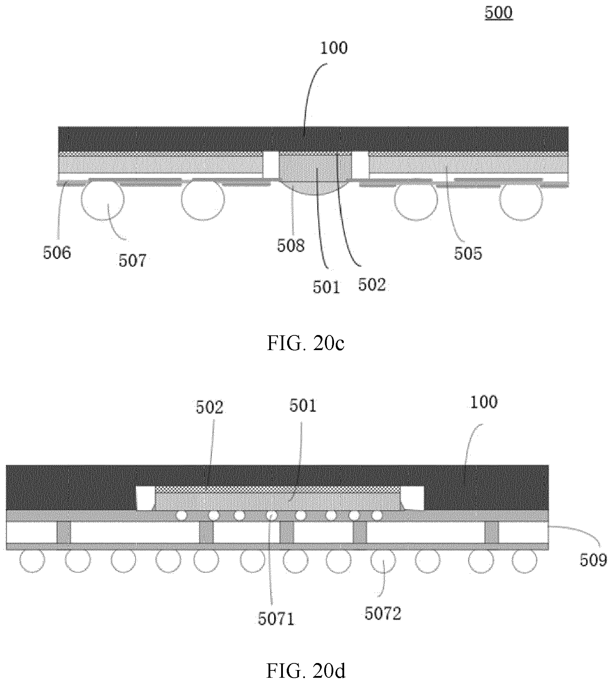

As shown in FIG. 20a, FIG. 20b, FIG. 20c, and FIG. 20d, embodiments of this application further provide a semiconductor structure 500. The semiconductor structure 500 includes a semiconductor chip 501 and the carbon material 100 in embodiments of this application. The carbon material 100 covers the semiconductor chip 501, and the carbon material 100 is configured to equalize heat and dissipate heat for the semiconductor chip 501. The carbon material 100 may partially or fully cover the semiconductor chip 501. The carbon material in embodiments of this application has good heat-conducting property and a low thermal expansion rate. This helps reduce thermal stress in the semiconductor chip 501. In addition, the carbon material is light in mass. This helps reduce a weight of the semiconductor structure. In this application, a specific structural design of the semiconductor structure 500 is not limited, and the semiconductor structure 500 may be in various structural forms, for example, structural forms shown in FIG. 20a, FIG. 20b, FIG. 20c, and FIG. 20d. As shown in FIG. 20a, the carbon material 100 may directly replace an existing metal thermal pad, and be combined with the semiconductor chip 501 by using a thermal interface layer 502. As shown in FIG. 20b, the carbon material 100 may alternatively be attached to a metal thermal pad 503, and then be combined with the semiconductor chip 501 by using a thermal interface layer 502, to be specific, the carbon material 100 is used in combination with the metal thermal pad 503. The thermal interface layer 503 may be made of an organic or inorganic material. The semiconductor chip 502 may be various functional chips, and the semiconductor structure may alternatively include a plurality of semiconductor chips 501. The semiconductor structure 500 may be specifically a semiconductor packaged structure, and the semiconductor structure 500 further includes a package body 504 configured to package the semiconductor chip 501. As shown in FIG. 20a and FIG. 20b, a part of the carbon material 100 is packaged in the package body 504, and a surface on one side of the carbon material 100 is exposed outside the package body 504. The package body 504 may be various materials that may be used for packaging a semiconductor. For example, the package body 504 may be a plastic package body. As shown in FIG. 20c, in some embodiments, the semiconductor structure 500 further includes a metal layer 505 stacked on the carbon material 100 by using a thermal interface layer 502, a ground layer 506 stacked on the metal layer 505, a solder ball 507 for connecting to a circuit board, and a sealing layer 508 for protecting the semiconductor chip 501. As shown in FIG. 20d, in some embodiments, the semiconductor packaged structure further includes a circuit board 509, a solder ball 5071, and a solder ball 5072. The semiconductor chip 501 is connected to a circuit board 509 through the solder ball 5071, and the solder ball 5072 is used for connecting to another circuit board.

In this application, "-" indicates a range, including endpoint values at two ends. For example, 40 MPa-80 MPa includes endpoint values 40 MPa and 80 MPa, and any value between the two endpoint values.

The following further describes embodiments of this application by using a plurality of embodiments.

Embodiments 1 to 6

Preparation of graphite oxide with a large particle size by using a low-temperature process: Flake graphite with specific mass and with a particle size of approximately 150 nm is weighed, and 0.095 g/mL potassium permanganate and 95 wt % concentrated sulphuric acid are gradually added. Oxidation reaction temperature is controlled to be 35°C, and reaction time is controlled to be 3 h. Graphite oxide obtained through an oxidation reaction is washed to obtain a graphite oxide solution with a large particle size. A D50 size of the obtained graphite oxide with a large particle size is greater than 100 $\mu$m, and oxygen content of the graphite oxide is approximately 0.35. The D50 size of the graphite oxide is obtained through detection by using a laser particle size analyzer. The oxygen content of the graphite oxide may be obtained by using an EA (Elemental Analyzer, elemental analyzer).

Graphitization and biaxial stretching with a catalyst: Graphite oxide prepared by using a low-temperature process is dispersed in NMP, and a catalyst is added to prepare a graphite oxide slurry with a solid content of 2%. The graphite oxide slurry is applied to a substrate, with a coating thickness of 3.5 mm. Then the substrate is baked in an oven at a temperature of 150°C, and is baked for 30 min and then taken out. A dried graphite oxide sheet is soaked and then undergoes biaxial stretching, and is pressed by a roller machine at 5 MPa into a graphite oxide film with a thickness of 0.5 mm. Then graphitization is performed through heat treatment at 2900°C to 3200°C for 1 h. Then rolling is performed at 70 MPa to obtain a carbon material with a thickness of 200 $\mu$m.

Catalysts and biaxial stretching process parameters used in Embodiments 1 to 6 and parameter results of obtained carbon materials are shown in Table 1.

**Table 1 Process parameters and carbon material characterization results**

| Embodiment | Embodiment 1 | Embodiment 2 | Embodiment 3 | Embodiment 4 | Embodiment 5 | Embodiment 6 |
|---|---|---|---|---|---|---|
| Catalyst type and usage | Ferric acetylacetonate, 0.02% | Ferrous oxalate, 0.02% | Ferric acetylacetonate, 0.05% | Ferrous oxalate, 0.05% | Ferric chloride, 0.02% | Nickel chloride, 0.02% |
| Temperature for graphitizatio n | 3200°C | 3000°C | 2900°C | 3200°C | 3200°C | 3200°C |
| Weight for biaxial stretching | 15 kg | 15 kg | 15 kg | 15 kg | 15 kg | 15 kg |

(continued)

| Embodiment | Embodiment 1 | Embodiment 2 | Embodiment 3 | Embodiment 4 | Embodiment 5 | Embodiment 6 |
|---|---|---|---|---|---|---|
| Proportion of turbostratic stacking of carbon atom layers (%) | 23 | 20 | 21 | 22 | 25 | 23 |
| Thermal diffusivity (mm$^2$/s) | 867 | 786 | 824 | 853 | 952 | 921 |
| $L_c$ size (nm) | 56 | 52 | 53 | 55 | 62 | 58 |
| $L_a$ size ($\mu$m) | 42 | 28 | 36 | 39 | 55 | 47 |
| Distance between carbon layers (nm) | 0.342 | 0.355 | 0.339 | 0.345 | 0.336 | 0.337 |
| Proportion of C=C (%) | 86 | 84 | 85 | 87 | 91 | 88 |
| Elongation at break (%) | 4.5 | 3.5 | 5.5 | 5.9 | 6.2 | 6.1 |
| Breaking strength (MPa) | 45 | 42 | 48 | 52 | 55 | 49 |
| Maximum achievable thickness of a pristine film | 2 mm | 2 mm | 2 mm | 2 mm | 2 mm | 2 mm |
| Surface roughness | 0.72 $\mu$m | 0.91 $\mu$m | 0.95 $\mu$m | 0.81 $\mu$m | 0.57 $\mu$m | 0.59 $\mu$m |

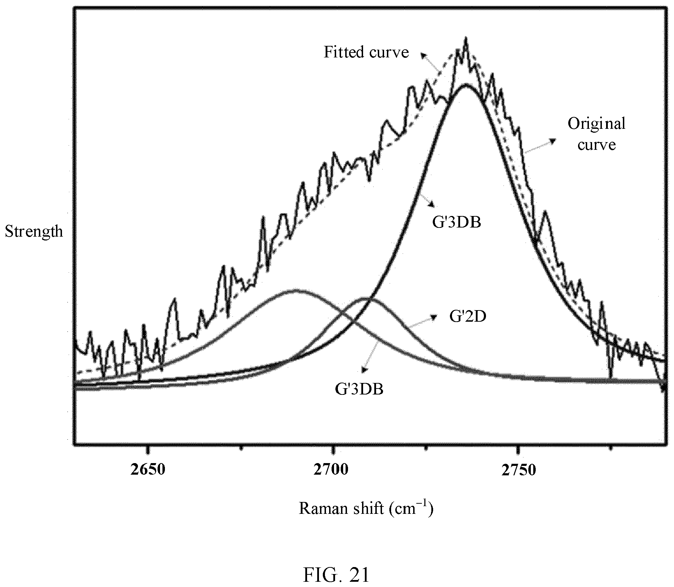

Embodiment 1 is used as an example. The proportion of turbostratic stacking of carbon atom layers of the carbon material in Table 1 is calculated as follows: A signal on a surface of the carbon material is observed. A test wavelength ranges from 1200 to 2800 (cm$^{-1}$), and focus is put on a band of 2500 cm$^{-1}$ to 2800 cm$^{-1}$ (G' peak). A Lorentzian peak-differentiation-fitting curve for the G' peak is provided, as shown in FIG. 21. The proportion R of turbostratic stacking of carbon atom layers is calculated by using the following formula (1):

$$R = \left| \frac{I_{G'_{3DB}}}{I_{G'_{3DB}} + I_{G'_{2D}}} \right|$$

Formula (1)

In the formula (1), $I_{G'3DB}$ and $I_{G'2D}$ are respectively peak values on a G'3DB spectral band and a G'2D spectral band in FIG. 10.

It can be learned from the results in Table 1 that, in this application, a carbon material with a high proportion of turbostratic stacking is obtained by using a specific preparation process. The carbon material has superb heat-diffusion property and bendability and a characteristic of a thick pristine film, and can meet a heat dissipation requirement of a device with a high heat flux, and meet a requirement for a heat dissipation carbon material with a thick pristine film. This facilitates highly integrated and miniaturized development of an electronic device.

**Claims**

1. A carbon material, wherein the carbon material comprises a plurality of stacked carbon atom layers, a proportion of interlayer turbostratic stacking of the plurality of stacked carbon atom layers in the carbon material is greater than or equal to 20%, and in-plane thermal diffusivity of the carbon material is greater than or equal to 750 mm$^2$/s.

2. The carbon material according to claim 1, wherein a crystallographic $L_c$ size of a grain of the carbon material is greater than or equal to 50 nm.

3. The carbon material according to claim 1 or 2, wherein a proportion of C=C in the carbon material is greater than or equal to 80%.

4. The carbon material according to any one of claims 1 to 3, wherein the carbon material has a pristine film characteristic within a thickness range of less than or equal to 2 mm.

5. The carbon material according to any one of claims 1 to 4, wherein the carbon material is bendable.

6. The carbon material according to any one of claims 1 to 5, wherein a crystallographic $L_a$ size of the grain of the carbon material is greater than or equal to 10 $\mu$m.

7. The carbon material according to any one of claims 1 to 6, wherein an interlayer distance between the plurality of stacked carbon atom layers is greater than or equal to 0.3 nm and less than or equal to 0.5 nm.

8. The carbon material according to any one of claims 1 to 7, wherein elongation at break of the carbon material is greater than or equal to 1%.

9. The carbon material according to any one of claims 1 to 8, wherein breaking strength of the carbon material is greater than or equal to 30 MPa.

10. The carbon material according to any one of claims 1 to 9, wherein surface roughness Ra of the carbon material is less than or equal to 1 $\mu$m.

11. The carbon material according to any one of claims 1 to 10, wherein the carbon material comprises a carbon film, a carbon sheet, or a carbon plate.

12. The carbon material according to any one of claims 1 to 11, wherein the carbon material is obtained by graphitizing graphite oxide.

13. A device, wherein the device comprises the carbon material according to any one of claims 1 to 12.

14. An electronic device, wherein the electronic device comprises the carbon material according to any one of claims 1 to 12.

15. The electronic device according to claim 14, wherein the electronic device comprises a display, a middle frame, a rear cover, and a circuit board, the middle frame is configured to carry the display and the circuit board, the middle frame is located between the display and the rear cover, and the carbon material is disposed between the middle frame and the rear cover and/or between the middle frame and the display.

16. The electronic device according to claim 15, wherein the electronic device further comprises a two-phase liquid-cooled heat dissipation component, and the two-phase liquid-cooled heat dissipation component is fastened to a surface of the carbon material, or the two-phase liquid-cooled heat dissipation component is partially or fully embedded in the carbon material.

17. The electronic device according to claim 16, wherein the two-phase liquid-cooled heat dissipation component is bonded or welded to the carbon material.

18. The electronic device according to claim 16 or 17, wherein the two-phase liquid-cooled heat dissipation component comprises a heat pipe and/or a vapor chamber.

**19.** A heat dissipation module, wherein the heat dissipation module comprises the carbon material according to any one of claims 1 to 12.

**20.** The heat dissipation module according to claim 19, wherein the heat dissipation module comprises a base and a heat-dissipation fin disposed on the base, and the base and/or the heat-dissipation fin are made of the carbon material.

**21.** The heat dissipation module according to claim 20, wherein the heat dissipation module further comprises a heat pipe and/or a vapor chamber connected to the base and the heat-dissipation fin.

**22.** A battery system, wherein the battery system comprises the carbon material according to any one of claims 1 to 12.

**23.** The battery system according to claim 22, wherein the battery system comprises a plurality of battery packs, each battery pack comprises a plurality of batter cells connected in series, and the carbon material is disposed between the plurality of battery packs and/or between the plurality of battery cells connected in series.

**24.** A semiconductor structure, wherein the semiconductor structure comprises a semiconductor chip and a carbon material covering the semiconductor chip, and the carbon material comprises the carbon material according to any one of claims 1 to 12.

<u>100</u>

FIG. 1a

FIG. 1b

FIG. 1c

FIG. 2a

FIG. 2b

Thermal diffusivity (mm²/s)　　　　　Proportion of Ts (%)

FIG. 3

Thermal diffusivity (mm²/s)

FIG. 4

FIG. 5a

FIG. 5b

FIG. 6a

FIG. 6b

Thermal diffusivity
$(mm^2/s)$

750 —

600 —

This application

450 —

Control group

FIG. 7

200

FIG. 8

FIG. 9a

FIG. 9b

201

100

202

203

100

204

205

205

FIG. 9c

2033 2033 2032 100

2031 203

FIG. 9d

2033 2033 2032 100

2031

2031

203

100 2031 2033

FIG. 9e

202

y

x

100

FIG. 10

FIG. 11

FIG. 12

FIG. 13

300

302

301

FIG. 14

300

302

2051

301

FIG. 15

FIG. 16a

FIG. 16b

FIG. 17

400

100

410

412

413

411

FIG. 18

410

411  100  411

FIG. 19

500

100

504

502    501

FIG. 20a

500

100    503

504

502    501

FIG. 20b

500

100

FIG. 20c

506    507    508    501  502    505

502    501    100

509

5071    5072

FIG. 20d

FIG. 21

## INTERNATIONAL SEARCH REPORT

| | International application No. |
|---|---|
| | **PCT/CN2022/128267** |

**A.      CLASSIFICATION OF SUBJECT MATTER**

C01B 32/00(2017.01)i;  C01B 32/205(2017.01)i;  C01B 32/21(2017.01)i;  H05K 7/20(2006.01)i

According to International Patent Classification (IPC) or to both national classification and IPC

**B.      FIELDS SEARCHED**

Minimum documentation searched (classification system followed by classification symbols)

C01B; H05K

Documentation searched other than minimum documentation to the extent that such documents are included in the fields searched

Electronic data base consulted during the international search (name of data base and, where practicable, search terms used)

CNTXT, ENTXTC, VEN, WEB OF SCIENCE, CNKI: 碳材, 石墨烯, 旋转堆叠, 菱形, 棱形, 热扩散, 层间距, ABC, BCA, ABA, rhombohedral, +layer, graphene, sheet+, thermal, diffus+, prismatic

**C.      DOCUMENTS CONSIDERED TO BE RELEVANT**

| Category* | Citation of document, with indication, where appropriate, of the relevant passages | Relevant to claim No. |
|---|---|---|
| PX | CN 113929074 A (HUAWEI TECHNOLOGIES CO., LTD.) 14 January 2022 (2022-01-14) claims 1-24 | 1-24 |
| X | YOUNES Henni et al. "Rhombohedral Multilayer Graphene: A Magneto-Raman Scattering Study" *Nano Letters*, 10 March 2016 (2016-03-10), page 3712, left column, page 3713, right column, page 3715, left column | 1, 5, 8, 9, 11, 24 |
| X | JP 2003308838 A (MITSUBISHI CHEMICAL CORP.) 31 October 2003 (2003-10-31) description, paragraph [0014] | 1, |
| Y | YOUNES Henni et al. "Rhombohedral Multilayer Graphene: A Magneto-Raman Scattering Study" *Nano Letters*, 10 March 2016 (2016-03-10), page 3712, left column, page 3713, right column, page 3715, left column | 13-24 |
| Y | CN 111654996 A (HUAWEI TECHNOLOGIES CO., LTD.) 11 September 2020 (2020-09-11) description, paragraphs [0108]-[0112] | 13-18 |
| Y | US 2016079639 A1 (PINON JAMES O) 17 March 2016 (2016-03-17) claims 1-24 | 19-23, |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 January 2023** | **28 January 2023** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2022/128267**

| Category* | Citation of document, with indication, where appropriate, of the relevant passages | Relevant to claim No. |
|---|---|---|
| A | US 2014178688 A1 (TOUR JAMES M et. al.) 26 June 2014 (2014-06-26) entire document | 1-24 |
| A | CN 112110440 A (INSTITUTE OF METAL RESEARCH, CHINESE ACADEMY OF SCIENCES) 22 December 2020 (2020-12-22) entire document | 1-24 |

Form PCT/ISA/210 (second sheet) (January 2015)

**INTERNATIONAL SEARCH REPORT**
Information on patent family members

International application No.

**PCT/CN2022/128267**

| Patent document cited in search report | | | Publication date (day/month/year) | Patent family member(s) | | | Publication date (day/month/year) |
|---|---|---|---|---|---|---|---|
| CN | 113929074 | A | 14 January 2022 | CN | 113929074 | B | 23 August 2022 |
| JP | 2003308838 | A | 31 October 2003 | JP | 3969164 | B2 | 05 September 2007 |
| CN | 111654996 | A | 11 September 2020 | EP | 3843366 | A1 | 30 June 2021 |
| | | | | US | 2021392782 | A1 | 16 December 2021 |
| | | | | WO | 2020078178 | A1 | 23 April 2020 |
| | | | | CN | 111654996 | B | 17 December 2021 |
| US | 2016079639 | A1 | 17 March 2016 | WO | 2017048423 | A1 | 23 March 2017 |
| | | | | CN | 108028324 | A | 11 May 2018 |
| | | | | EP | 3391429 | A1 | 24 October 2018 |
| US | 2014178688 | A1 | 26 June 2014 | US | 10053366 | B2 | 21 August 2018 |
| CN | 112110440 | A | 22 December 2020 | CN | 112110440 | B | 14 January 2022 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111278314
- GB 400692021 T
- GB 225882008 T
- GB 130221991 T